(19) **Europäisches Patentamt**
**European Patent Office**
**Office européen des brevets**

(11) **EP 4 773 032 A1**

(12) **EUROPEAN PATENT APPLICATION**
published in accordance with Art. 153(4) EPC

(43) Date of publication:
**08.07.2026 Bulletin 2026/28**

(21) Application number: **24909810.4**

(22) Date of filing: **12.08.2024**

(51) International Patent Classification (IPC):
**G06F 30/13** (2020.01)

(52) Cooperative Patent Classification (CPC):
**G06F 30/13**

(86) International application number:
**PCT/CN2024/111500**

(87) International publication number:
**WO 2025/138858 (03.07.2025 Gazette 2025/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 28.12.2023  CN 202311834483
28.12.2023  CN 202311834491
28.12.2023  CN 202311840242
28.12.2023  CN 202311841263
28.12.2023  CN 202311840424
28.12.2023  CN 202311841390
28.12.2023  CN 202311834148
28.12.2023  CN 202311841400

(71) Applicant: **Beijing Dynaflow Lab Solutions Co., Ltd.**
**Beijing 100070 (CN)**

(72) Inventors:
• **CHI, Haipeng**
**Beijing 100070 (CN)**
• **ZHANG, Huaidong**
**Beijing 100070 (CN)**
• **XING, Xixue**
**Beijing 100070 (CN)**
• **XI, Xiaopeng**
**Beijing 100070 (CN)**
• **ZHANG, Jingjun**
**Beijing 100070 (CN)**
• **GONG, Changhua**
**Beijing 100070 (CN)**

(74) Representative: **Bayramoglu et al.**
**Mira Office**
**Kanuni Sultan Süleyman Boulevard 5387**
**Street Beytepe, floor 12, no:50**
**06800 Cankaya, Ankara (TR)**

(54) **BIM-BASED PREFABRICATED BUILDING DESIGN SYSTEM AND SIMULATED ASSEMBLY METHOD**

(57) A BIM-based prefabricated building design system and a simulation assembly method. The system includes a data acquisition module, a BIM modeling module, a drawing generation module, a component processing module, an assembly module, and a verification module. The data acquisition module is configured to collect data information of a prefabricated building; the BIM modeling module is configured to construct a BIM model of the prefabricated building according to the data information; the drawing generation module is configured to export a building component drawing according to the BIM model; the component processing module is configured to perform production manufacturing according to the building component drawing; the assembly module is configured to perform assembly path planning on a manufactured building component, and perform assembly based on a planned path; and the verification module is configured to verify an assembled building. Therefore, integration of a prefabricated building design is realized, and the intelligent hoisting of a prefabricated building is achieved, thereby ensuring that assembly can be accurately completed.

| Data acquisition module | BIM modeling module | Drawing generation module | Component processing module | Assembly module | Verification module |
|---|---|---|---|---|---|

**Fig. 1**

EP 4 773 032 A1

## Description

The present disclosure claims priority to Chinese Patent Application Nos. 202311834483.0, 202311834491.5, 202311840242.7, 202311841263.0, 202311840424.4, 202311841390.0, 202311834148.0, and 202311841400.0, the disclosures of which are hereby incorporated by reference in their entirety.

## Technical Field

The present disclosure belongs to the technical field of computers, and specifically to a BIM-based prefabricated building design system and a simulation assembly method.

## Background

Traditional construction operations are generally based on two-dimensional drawings. Due to the multitude of specialties within construction engineering and the relative independence of professional technical drawings, information based on traditional management manner cannot be effectively linked. During the construction phase, professional drawings need to be interleaved and summarized for use, and thus this manner may lead to inconsistencies in drawing information.

A prefabricated building is an emerging systematic project that requires the cross-operation of various professional techniques for its construction. Good coordination among all professional techniques is essential to ensure efficient and safe construction of work processes. Therefore, in order to achieve high-quality prefabricated building construction, it is necessary to perform refined management on the construction processes with the help of information technologies. Introducing a BIM virtual simulation technology into construction can integrate elements such as software, drawings, and the like used across specialties, thereby improving communication efficiency among all specialties.

## Summary

The present disclosure is mainly intended to provide a BIM-based prefabricated building design system and a simulation assembly method, so as to achieve the integration and intelligence of a prefabricated building design, thereby improving assembly accuracy.

In order to solve the above problem, the present disclosure relates to a BIM-based prefabricated building design system. The system includes: a data acquisition module, a BIM modeling module, a drawing generation module, a component processing module, an assembly module, and a verification module.

The data acquisition module is configured to collect data information of a prefabricated building; the BIM modeling module is configured to construct a BIM model of the prefabricated building according to the data information; the drawing generation module is configured to export a building component drawing according to the BIM model; the component processing module is configured to perform production manufacturing according to the building component drawing; the assembly module is configured to perform assembly path planning on a manufactured building component, and perform assembly based on a planned path; and the verification module is configured to verify an assembled building.

Further, the data acquisition module includes a design unit, a screening unit, and a data conversion unit.

The design unit is configured to perform simulation analysis on a site and an environment, build a mass model by a designer, and generate a design solution of the prefabricated building; the screening unit is configured to build an analysis model on the basis of the mass model to perform simulation analysis, perform solution comparison by analyzing data and comprehensive factors, and estimate a structure form selection to determine an optimal solution; and the data conversion unit is configured to convert the optimal solution into data information for constructing the BIM model of the prefabricated building.

Further, the BIM modeling module includes a construction unit, a fusion unit, a creation unit, and a detection unit.

The construction unit is configured to construct an initial building BIM model and an initial structural BIM model according to the data information of the prefabricated building; the fusion unit is configured to fuse the initial building BIM model and the initial structural BIM model to acquire an integrated BIM model; the creation unit is configured to create a prefabricated BIM model according to the integrated BIM model; and the detection unit is configured to detect the prefabricated BIM model according to the integrated BIM model, and modify the prefabricated BIM model according to a detection result, in a case where there is a difference between the two models, so as to obtain the final BIM model.

Further, the drawing generation module includes a setting unit, a classification unit, and a storage unit.

The setting unit is configured to delete basic information in the BIM model, reserve component names and corresponding dimension data, and export the corresponding building component drawing; the classification unit is configured to classify the building component drawings; and the storage unit is configured to store the exported building component drawing.

Further, the component processing module monitors the processing of a building component by using a processing plant according to the exported building component drawing.

Further, the assembly module includes an image acquisition unit, an analysis unit, a control unit, and a monitoring unit.

The image acquisition unit is configured to collect image data of a construction site; the analysis unit is configured to analyze the image data to acquire an optimal assembly path; the control unit is configured to control an assembly process of a building component according to the optimal assembly path; and the monitoring unit is configured to acquire a real-time image of the assembly process, and monitor whether the building component in the real-time image is assembled according to the planned optimal assembly path.

Further, a deep learning model constituted by using a CNN and a T2FNN in the analysis unit is configured to analyze real-time image data of a prefabricated building hoisting construction site acquired by the image acquisition unit, find an obstacle affecting prefabricated building hoisting, determine an obstacle position through a raster table, and find an optimal assembly path of a prefabricated part of the prefabricated building through an ant colony algorithm; and send the optimal assembly path of the prefabricated component to the control unit.

Further, the verification module includes a graphics acquisition unit, a comparison unit, and a reassembly unit.

The graphics acquisition unit is configured to acquire laser scanning data after building assembly, and construct a real-time assembly model of a building based on the laser scanning data; the comparison unit is configured to perform matching degree comparison on the real-time assembly model and the BIM model constructed by the BIM modeling module; and the real-time assembly model is configured to identify an assembly error according to a comparison result, and reassemble an error region according to the BIM model after identifying the assembly error.

Further, the system further includes a construction simulation module, a scenario simulation module, and a three-dimensional display module.

The construction simulation module is connected to the data acquisition module and configured to perform component simulation and construction simulation based on the data information of the prefabricated building to obtain a simulation result; the scenario simulation module is connected to the construction simulation module and configured to simulate the simulation result in different scenarios; and the three-dimensional display module is configured to perform three-dimensional display on a construction simulation process and the simulation result.

Further, the construction simulation module includes an analysis unit, a component unit, a construction unit, and a warning unit.

The analysis unit is configured to construct a component based on the data information of the prefabricated building, so as to obtain component data; the component data comprises a component shape and the number of the corresponding components; the construction unit is configured to generate a simulation component based on the component data; the construction unit is configured to perform construction simulation based on the simulation component; and the warning unit is configured to issue a warning for a dangerous event occurring during construction simulation.

Further, the system further includes a collision warning module and a solution recording module.

The collision warning module is configured to monitor a collision event during simulation assembly, so as to issue a collision warning; and the solution recording module is configured to record an assembly process, output a final assembly construction solution by reforming the simulation assembly process, and simulate and demonstrate the assembly construction solution.

Further, the system further includes a model database and a load testing module.

The model database is configured to store 3D models of building materials required for constructing a laboratory; and the load testing module is configured to perform a load test on an assembled building model.

Further, the system further includes a pipeline mounting simulation system. The pipeline mounting simulation system includes a three-dimensional modeling module, a simulation module, a parameter setting module, and a visualization module.

The three-dimensional modeling module is configured to create and edit a pipeline information model by using BIM software; the simulation module is configured to simulate a pipeline mounting process based on the pipeline information model; the parameter setting module is configured to set a pipeline parameter during pipeline mounting; and the visualization module is configured to display a simulation result.

Further, the pipeline mounting simulation system further includes a pipeline classification and counting module, a market price statistics module, and a pipeline cost accounting module.

The pipeline classification and counting module is configured to classify pipelines in the pipeline information model, and mark and count each category of pipelines, respectively, so as to obtain the number of different types of pipelines; the market price statistics module is configured to perform statistics on the price and quality of pipelines in the market; and the pipeline cost accounting module is configured to perform solution generation according to the price and quality of pipelines in the market and the number of different types of pipelines, so as to obtain different pipeline mounting solutions, and perform cost accounting on the pipeline mounting solutions.

Further, the three-dimensional modeling module includes a point cloud scanning sub-module, a point cloud pre-processing sub-module, a pipeline extraction sub-module, and a model construction sub-module.

The point cloud scanning sub-module is configured to scan a construction drawing by using SL-100D, so as to acquire point cloud data of a building; the point cloud pre-processing sub-module is configured to perform pre-processing of format conversion, data fusion, redundancy removal, point cloud coloring, and point cloud segmentation on the point cloud data; the pipeline extraction sub-module is configured to perform pipeline extraction on pre-processed point cloud; and the model construction sub-module is configured to generate a two-dimensional pipeline distribution diagram based on an extracted pipeline and the pre-processed point cloud, and construct a BIM three-dimensional model of the pipeline distribution diagram by using Revit software.

Further, the pipeline classification and counting module further includes a pipeline classification sub-module and a pipeline counting sub-module.

The pipeline classification sub-module is configured to perform pipeline classification according to different types of coloring based on a point cloud coloring effect in the point cloud pre-processing sub-module; and the pipeline counting sub-module is configured to count the number of pipelines based on pipeline point cloud coloring in the pipeline classification sub-module.

Further, counting the number of pipelines based on pipeline point cloud coloring in the pipeline classification sub-module specifically includes the following operations.

A picture for pipeline point cloud coloring is acquired, and the picture is divided into PR, PG, and PB pictures according to three primary colors; the PR, PG, and PB pictures are adjust to filter a lower limit of a color value of the background to remove background and noise of the pictures, so as to obtain de-noised images with the same size with the pictures; grayscale conversion is performed on the de-noised images, and edges of grayscale images are blurred through Gaussian filtering, so as to obtain filtered de-noised images; erosion expansion is performed on the filtered de-noised images, and then an external contour of a pipeline is detected through an edge tracking algorithm, so as to acquire external contours of N pipelines in the grayscale images, where $N \geq 1$; all pixel points of the external contours of the pipelines are constituted based on the external contour of each pipeline, whether a gradient of each pixel point is the largest among surrounding pixel points with a same gradient direction is decided, and if so, a current pixel point is reserved, otherwise the current pixel point is removed; and whether the number of pixel points of the external contour of the current pipeline is less than a set threshold is decided, and the pixel points of the external contour of the current pipeline are extracted, so as to filter external contours of M pipelines among the external contours of the N pipelines, where $1 \leq M \leq N$.

A convex hull function is further used on the screened external contours of the M pipelines to obtain each pixel point forming the contour around the entire pipeline, so as to obtain the accurate external contours of the M pipelines.

The number of pipelines is obtained according to the number of the external contours.

Further, the market price statistics module includes an object positioning sub-module, a matching and supplementation sub-module, and a pipeline-related data sub-module.

The object positioning sub-module is configured to position commodities similar to the pipelines in the market.

The matching and supplementation sub-module is configured to supplementing the similar commodity by combining a fuzzy matching method.

The pipeline-related data sub-module is configured to acquire the pipeline commodities and related data of products similar to the pipelines according to the supplemented similar commodities.

Further, positioning the commodities similar to the pipelines in the market specifically includes the following operations.

A clustering algorithm is used to position a similar product.

Characteristic attributes of the pipelines are manually labeled.

Searchable approximate corpora similar to the pipelines is manually labeled.

A similarity search language model is established based on a natural language processing technology and the approximate corpora.

The commodities similar to the pipelines are clustered based on a semi-supervised natural language processing technology and the similarity search language model.

According to a second aspect of the present disclosure, a BIM-based prefabricated building simulation assembly method is provided. The assembly method is applied to the above assembly system, and includes the following steps.

At S1, data information of a building to be assembled is collected, and the data information is analyzed.

At S2, a BIM model of a prefabricated building is constructed according to the data information.

At S3, a building component drawing is exported according to the BIM model.

At S4, assembly path planning is performed on a manufactured building component, and assembly is performed based on a planned path.

The present disclosure has the following beneficial effects. In the BIM-based prefabricated building design system provided in the present disclosure, the data acquisition module, the BIM modeling module, and the drawing generation module, the component processing module, and the assembly module are arranged, and the design solution, manufacturing requirements, and mounting requirements are integrated in the prefabricated building design system, such that the integration of the prefabricated building design is realized, problems generated during actual manufacturing and mounting can be eliminated in advance, overall efficiency of manufacturing and mounting is improved, and a construction period is shortened. In the present disclosure, the assembly module performs assembly path planning on the manufactured building component, such that intelligent hoisting of a prefabricated building is achieved, man power is saved, and the disadvantage of manual hoisting is avoided, thereby shortening hoisting time, facilitating improvement of the hoisting efficiency and accuracy of the prefabricated building, and reducing hoisting difficulty. In the present disclosure, the verification module verifies the assembled building, ensuring that assembly can be accurately completed.

## Brief Description of the Drawings

The accompanying drawings described herein are used to provide a further understanding of the present disclosure, constitute a part of the present disclosure, so that other features, objectives and advantages of the present disclosure become more apparent. The exemplary embodiments of the present disclosure and the description thereof are used to explain the present disclosure, but do not constitute improper limitations to the present disclosure. In the drawings:

Fig. 1 is a schematic diagram of a BIM-based prefabricated building design system according to a first embodiment of the present disclosure.
Fig. 2 is a schematic diagram of a BIM-based prefabricated building design system according to a second embodiment of the present disclosure.
Fig. 3 is a flowchart of a BIM-based prefabricated building simulation assembly method according to a third embodiment of the present disclosure.
Fig. 4 is a schematic diagram of a BIM-based prefabricated building design system according to a fourth embodiment of the present disclosure.
Fig. 5 is a schematic diagram of a BIM-based prefabricated building design system according to a fifth embodiment of the present disclosure.
Fig. 6 is a flowchart of a BIM-based prefabricated building simulation assembly method according to a sixth embodiment of the present disclosure.
Fig. 7 is a schematic diagram of a BIM-based prefabricated building design system according to a seventh embodiment of the present disclosure.
Fig. 8 is a schematic diagram of a BIM-based prefabricated building design system according to an eighth embodiment of the present disclosure.
Fig. 9 is a flowchart of an automatic riveting method according to a ninth embodiment of the present disclosure.
Fig. 10 is a structural diagram of an automatic riveting system according to a ninth embodiment of the present disclosure.
Fig. 11 is a schematic diagram of piecewise linear transformation according to a ninth embodiment of the present disclosure.
Fig. 12 is a schematic diagram of a riveting appearance evaluation system according to a tenth embodiment of the present disclosure.

## Detailed Description of the Embodiments

It is to be noted that the embodiments in the present disclosure and the features in the embodiments may be combined with one another without conflict. The present disclosure will be described below in detail with reference to the drawings and the embodiments.

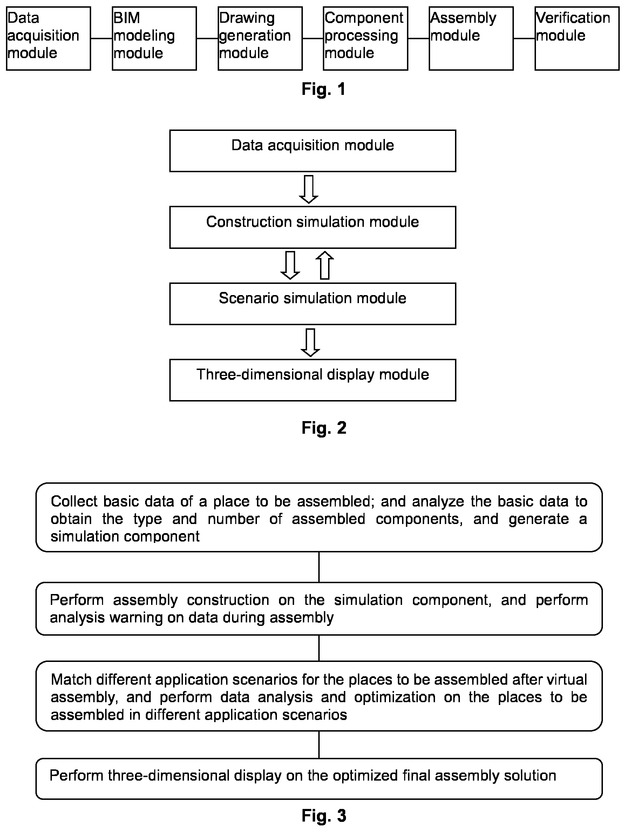

As shown in Fig. 1, this embodiment provides a BIM-based prefabricated building design system, including: a data acquisition module, a BIM modeling module, a drawing generation module, a component processing module, an assembly module, and a verification module.

The data acquisition module is configured to collect data information of a prefabricated building.

The BIM modeling module is configured to construct a BIM model of the prefabricated building according to the data information.

The drawing generation module is configured to export a building component drawing according to the BIM model.

The component processing module is configured to perform production manufacturing according to the building component drawing.

The assembly module is configured to perform assembly path planning on a manufactured building component, and perform assembly based on a planned path.

The verification module is configured to verify an assembled building.

The data acquisition module includes a design unit, a screening unit, and a data conversion unit.

The design unit is configured to perform simulation analysis on a site and an environment, build a mass model by a designer, and generate a design solution of the prefabricated building.

The screening unit is configured to build an analysis model on the basis of the mass model to perform simulation analysis, perform solution comparison by analyzing data and comprehensive factors, and estimate a structure form selection to determine an optimal solution.

The data conversion unit is configured to convert the optimal solution into data information for constructing the BIM model of the prefabricated building.

In this embodiment, the data acquisition module is a concept design and solution determination phase for prefabricated building design. Through simulation analysis of a site, an environment, etc., the designer performs concept design, determines solution mass and function division, and builds the mass model. On the basis of concept design, the optimal mass is used to perform solution creation, the analysis model is built for simulation analysis on the basis of the mass model, solution comparison is performed by analyzing the data and comprehensive factors, and the structure form selection is estimated to determine the optimal solution. The designer performs project requirement evaluation, and a construction designer describes the solution and estimates the structure form selection and component situations, so as to preliminarily form structure requirements. The designer deepens the solution, establishes a solution model on the basis of the analysis model, completes the solution design, and converts same into the data information configured to construct the BIM model of the prefabricated building.

The BIM modeling module includes a construction unit, a fusion unit, a creation unit, and a detection unit.

The construction unit is configured to construct an initial building BIM model and an initial structural BIM model according to the data information of the prefabricated building. A building BIM model is a building model carrying construction specialty parameter information. In the prefabricated building model, structures such as an enclosure wall, an internal partition wall, a bay window, staircases, an air conditioning panel, etc. that are not present in the professional BIM model are mainly extracted. A structural BIM model is a model composed of a horizontal load-bearing component and a vertical load-bearing component. The prefabricated building BIM model is complementary with the building professional BIM model during mold closing.

The fusion unit is configured to fuse the initial building BIM model and the initial structural BIM model to acquire an integrated BIM model. The model integrates all components for a building and a structure, so as to meet all component requirements required by a prefabricated design.

The creation unit is configured to create a prefabricated BIM model according to the integrated BIM model. The prefabricated building BIM model is a model that includes all building components. Based on the assembly solution, certain components are replaced with prefabricated elements to form the BIM model.

The detection unit is configured to detect the prefabricated BIM model according to the integrated BIM model, and modify the prefabricated BIM model according to a detection result, in a case where there is a difference between the two models, so as to obtain the final BIM model. Whether the prefabricated BIM model is consistent with the integrated BIM model is determined according to the detection result. In a case where the prefabricated BIM model is consistent with the integrated BIM model, the data consistency of each construction drawing in construction drawing data is ensured according to the construction drawing data generated by the integrated BIM model and prefabricated BIM model.

In this embodiment, a unified resource platform is established by a preset BIM design standard. The integrated BIM model is generated on the resource platform according to the building BIM model and the structural BIM model, and then the prefabricated BIM model is generated according to the integrated BIM model, such that through the linkage between the prefabricated BIM model and the integrated BIM model, when the verification result shows that a component of the prefabricated BIM model and a component of the integrated BIM model have inconsistent positions and dimensions or do not meet drawing review requirements, automatic adjustment may be realized to ensure the consistency of the construction drawing data, thereby reducing the workload of the designer, and improving the design efficiency of the designer. Therefore, the BIM platform-based prefabricated building design method may achieve the technical effect of improving the work efficiency of building design.

The drawing generation module includes a setting unit, a classification unit, and a storage unit.

The setting unit is configured to delete basic information in the BIM model, reserve component names and corresponding dimension data, and export the corresponding building component drawing. The exported drawing is clear and brief, and can be easily identified.

The classification unit is configured to classify the building component drawings; and the storage unit is configured to store the exported building component drawing. Automatic storage and categorization of assembled building drawings are completed by the classification unit and the storage unit.

The component processing module monitors the processing of a building component by using a processing plant according to the exported building component drawing.

The assembly module includes an image acquisition unit, an analysis unit, a control unit, and a monitoring unit.

The image acquisition unit is configured to collect image data of a construction site.

The analysis unit is configured to analyze the image data to acquire an optimal assembly path.

The control unit is configured to control an assembly process of a building component according to the optimal assembly path.

The monitoring unit is configured to acquire a real-time image of the assembly process, and monitor whether the building component in the real-time image is assembled according to the planned optimal assembly path.

The image acquisition module collects an image by a camera mounted in the prefabricated building hoisting construction site, constructs a machine vision database of the construction site, and transmits the image to an image analysis unit via a communication unit.

The image analysis unit finds the optimal hoisting path of the prefabricated part of the prefabricated building, and sends the optimal hoisting path to a device control unit via the communication unit. The control unit calculates data required for specific hoisting, and then implements prefabricated part hoisting by using a tower crane control module. During hoisting, a camera control module controls the camera to acquire the real-time image; whether the prefabricated part meets the set optimal hoisting path of the prefabricated part is decided by an image processing and decision-making module; and if there is a deviation, correction is performed by the tower crane control module, and if there is no deviation, prefabricated part hoisting is completed, and then a next prefabricated part is hoisted, until the overall hoisting of all prefabricated parts is completed.

A deep learning model constituted by using a CNN and a T2FNN in the analysis unit is configured to analyze real-time image data of a prefabricated building hoisting construction site acquired by the image acquisition unit, find an obstacle affecting prefabricated building hoisting, determine an obstacle position through a raster table, and find an optimal assembly path of a prefabricated part of the prefabricated building through an ant colony algorithm; and send the optimal assembly path of the prefabricated component to the control unit. This embodiment use the camera to replace human eyes to analyze the optimal solution from a complex scenario, such that the prefabricated part hoisting path can be better planned, the hoisting efficiency and accuracy of the prefabricated building are greatly improved, the intelligent hoisting of the prefabricated building is realized, thereby improving disadvantages of manual hoisting. The obtain optimal hoisting path ensures that the time for prefabricated part hoisting is the shortest and all on-site obstacles are avoided during hoisting, facilitating improvement of the hoisting efficiency and accuracy of the prefabricated building, thereby reducing hoisting difficulty.

The verification module includes a graphics acquisition unit, a comparison unit, and a reassembly unit.

The graphics acquisition unit is configured to acquire laser scanning data after building assembly, and construct a real-time assembly model of a building based on the laser scanning data.

The comparison unit is configured to perform matching degree comparison on the real-time assembly model and the BIM model constructed by the BIM modeling module.

The real-time assembly model is configured to identify an assembly error according to a comparison result, and reassemble an error region according to the BIM model after identifying the assembly error.

In this embodiment, by performing matching degree identification on graphics after the graphics are assembled, an assembly error may be identified automatically, the error region is detected again after the error is identified, and then assembly is re-completed according to the BIM model, causing the assembly to be able to be completed accurately.

In another optional embodiment of the present disclosure, as shown in Fig. 2, a BIM-based prefabricated building design system is provided. The system includes a data acquisition module, a construction simulation module, a scenario simulation module, and a three-dimensional display module. The data acquisition module is configured to perform data acquisition on a place to be assembled, and transmit data for the place to be assembled to the construction simulation module; the construction simulation module is connected to the data acquisition module and configured to perform component simulation and construction simulation based on the data for the place to be assembled to obtain a simulation result; the scenario simulation module is connected to the construction simulation module and configured to simulate the simulation result in different scenarios; and the three-dimensional display module is configured to perform three-dimensional display on a construction simulation process and the simulation result.

The construction simulation module includes an analysis unit, a routing unit, a component unit, a construction unit, and a warning unit. The analysis unit is configured to construct a component based on the data for the place to be assembled, so as to obtain component data; the component data includes a component shape and the number of the corresponding components; the construction unit is configured to generate a simulation component based on the component data; the construction unit is configured to perform construction simulation based on the simulation component; and the warning unit is configured to issue a warning for a dangerous event occurring during construction simulation. The routing unit is connected to the analysis unit and the warning unit. The analysis unit performs water and electricity routing design based on the data for the place to be assembled, and then the routing unit performs routing according to the design.

Specifically, first, the analysis unit uses the data for the place to be assembled to rationally design or split the components based on the principle of "fewer specifications, more combinations" followed in plan design, facilitating subsequent production, transportation, hoisting, etc. in an actual process. Then, dimensions of the split components are determined, and the volume of each component is determined based on the dimensions of the components. Then, material parameters of the components are determined, a construction weight is obtained in combination with the volume parameter, such that a simulation component with parameters such as the volume, weight, etc. is generated. The parameters such as volume, weight, etc. are configured to perform subsequent warning analysis.

In this embodiment, a constitutive model is established for the material parameters, so as to perform stress analysis. Specifically, in this embodiment, the material parameters include a reinforced steel material and a concrete material.

A constitutive model of the reinforced steel material includes the following.

$$\sigma_s = \begin{cases} E_s \varepsilon_s & \varepsilon_s \le \varepsilon_y \\ f_{y,r} & \varepsilon_y < \varepsilon_s \le \varepsilon_{uy} \\ f_{y,t} + k\left(\varepsilon_s - \varepsilon_{uy}\right) & \varepsilon_{uy} < \varepsilon_s \le \varepsilon_u \\ 0 & \varepsilon_s > \varepsilon_u \end{cases}.$$

In the formula, $\sigma_s$ represents reinforced steel stress; $E_s$ represents a reinforced steel elasticity modulus; $\varepsilon_s$ represents reinforced steel strain; $f_{y,r}$ represents a representative value of reinforced steel yield strength; $f_{st,r}$ represents a representative value of reinforced steel ultimate strength; $\varepsilon_y$ represents reinforced steel yield strain; $\varepsilon_{uy}$ represents reinforced steel hardening starting strain; $\varepsilon_u$ represents reinforced steel peak strain; and k represents a slope of a hardening section of reinforced steel.

A constitutive model of the concrete material includes the following.

$$\sigma = \left(1 - d_c\right) E_c \varepsilon$$

$$d_t = \begin{cases} 1 - \dfrac{\rho_c n}{n - 1 + x^n} & x \le 1 \\ 1 - \dfrac{\rho_c}{a_c\left(x - 1\right)^2 + x} & x > 1 \end{cases}$$

$$\rho_c = \frac{f_{c,r}}{E_c \varepsilon_{c,r}}$$

$$n = \frac{E_c \varepsilon_{c,r}}{E_c \varepsilon_{c,r} - f_{c,r}}$$

$$x = \frac{\varepsilon}{\varepsilon_{c,r}}.$$

In the formula, $d_c$ represents a concrete damage evolution parameter; $E_c$ represents a concrete elasticity modulus; $d_t$ represents the concrete damage evolution parameter; $\varepsilon_{c,r}$ represents a representative value of uniaxial compressive strength; $f_{c,r}$ represents peak compressive strain of concrete; and $a_c$ represents a parameter value of a descending section of a concrete uniaxial compressive strength-strain curve.

A construction sequence is set, and a construction progress is simulated at the same time, so as to control the construction progress. Moreover, in combination with the constitutive model of the material, a hoisting solution during the construction process is simulated to obtain a comparatively excellent hoisting solution. In order to better analyze a stress situation during the hoisting of the component, the hoisting solutions of different components are analyzed by using maximum equivalent plastic strain of concrete under all states and maximum principal stress nephogram of concrete. The hoisting solution includes flip lifting, demolding lifting, etc. During flip lifting, the maximum tensile stress of the concrete in a flip state and a lifting state is analyzed, by comparing with a standard value of axial tensile strength of the concrete, the position and number of anti-crack reinforced steels are analyzed, and cracks are prevented from generating under the common action of the anti-crack reinforced steels and the concrete. During demolding lifting, stress analysis is performed on a solution with or without a balance beam and corresponding three-point and four-point lifting solutions, a warning is issued for situations such as cracks, uneven stress, etc., and through solution adjustment, a component hoisting solution with more uniform stress distribution and smaller concrete damage is obtained.

The scenario simulation module includes a scenario construction unit, a scenario database, and a scenario analysis unit. The scenario construction unit is configured to construct different application scenarios and set parameters for the application scenarios; the scenario database is configured to store the application scenarios, and provide an application scenario invoking function; and the scenario analysis unit is configured to perform data analysis on places to be assembled in different application scenarios, so as to obtain an analysis result.

The application scenarios include application scenarios during practical application after assembly is complete, such as during hospital simulation assembly, in combination with a medical device. By simulating different application scenarios, an assembly structure and medical device placement may be optimized, achieving greater comfort and convenience.

The three-dimensional display module includes a display unit and a storage unit. The display unit is configured to perform three-dimensional display on the construction simulation process and the simulation result; and the storage unit is configured to provide a storage function, and store the simulation result.

In another optional embodiment of the present disclosure, Fig. 3 is a flowchart of a BIM-based prefabricated building simulation assembly method according to an embodiment of the present disclosure. As shown in Fig. 3, the method includes the following steps.

At S1, basic data of a place to be assembled is collected; and the basic data is analyzed to obtain the type and number of assembled components, and a simulation component is generated.

The data for the place to be assembled is used to rationally design or split the components based on the principle of "fewer specifications, more combinations" followed in plan design, facilitating subsequent production, transportation, hoisting, etc. in an actual process. Then, dimensions of the split components are determined, and the volume of each component is determined based on the dimensions of the components. Then, material parameters of the components are determined, a construction weight is obtained in combination with the volume parameter, such that a simulation component with parameters such as the volume, weight, etc. is generated. The parameters such as volume, weight, etc. are configured to perform subsequent warning analysis.

At S2, assembly construction is performed on the simulation component, and analysis warning is performed on data during assembly.

At S21, constitutive models of different materials are constructed.

At S22, a hoisting solution design is performed on different components, stress analysis is performed based on the constitutive models and the solution design to obtain a stress situation, and state warning is performed based on the stress situation.

Specifically, the constitutive model is established for material parameters of the components, so as to perform stress analysis.

In this embodiment, the material parameters include a reinforced steel material and a concrete material.

A constitutive model of the reinforced steel material includes the following.

$$\sigma_s = \begin{cases} E_s \varepsilon_s & \varepsilon_s \leq \varepsilon_y \\ f_{y,r} & \varepsilon_y < \varepsilon_s \leq \varepsilon_{uy} \\ f_{y,t} + k(\varepsilon_s - \varepsilon_{uy}) & \varepsilon_{uy} < \varepsilon_s \leq \varepsilon_u \\ 0 & \varepsilon_s > \varepsilon_u \end{cases}.$$

In the formula, $\sigma_s$ represents reinforced steel stress; $E_s$ represents a reinforced steel elasticity modulus; $\varepsilon_s$ represents reinforced steel strain; $f_{y,r}$ represents a representative value of reinforced steel yield strength; $f_{st,r}$ represents a representative value of reinforced steel ultimate strength; $\varepsilon_y$ represents reinforced steel yield strain; $\varepsilon_{uy}$ represents reinforced steel hardening starting strain; $\varepsilon_u$ represents reinforced steel peak strain; and k represents a slope of a hardening section of reinforced steel.

A constitutive model of the concrete material includes the following.

$$\sigma = \left(1 - d_c\right) E_c \varepsilon$$

$$d_t = \begin{cases} 1 - \dfrac{\rho_c n}{n - 1 + x^n} & x \le 1 \\[3mm] 1 - \dfrac{\rho_c}{a_c \left(x - 1\right)^2 + x} & x > 1 \end{cases}$$

$$\rho_c = \frac{f_{c,r}}{E_c \varepsilon_{c,r}}$$

$$n = \frac{E_c \varepsilon_{c,r}}{E_c \varepsilon_{c,r} - f_{c,r}}$$

$$x = \frac{\varepsilon}{\varepsilon_{c,r}}$$

.

In the formula, $d_c$ represents a concrete damage evolution parameter; $E_c$ represents a concrete elasticity modulus; $d_t$ represents the concrete damage evolution parameter; $\varepsilon_{c,r}$ represents a representative value of uniaxial compressive strength; $f_{c,r}$ represents peak compressive strain of concrete; and $a_c$ represents a parameter value of a descending section of a concrete uniaxial compressive strength-strain curve.

A construction sequence is set, and a construction progress is simulated at the same time, so as to control the construction progress. Moreover, in combination with the constitutive model of the material, a hoisting solution during the construction process is simulated to obtain a comparatively excellent hoisting solution. In order to better analyze a stress situation during the hoisting of the component, the hoisting solutions of different components are analyzed by using maximum equivalent plastic strain of concrete under all states and maximum principal stress nephogram of concrete. The hoisting solution includes flip lifting, demolding lifting, etc. During flip lifting, the maximum tensile stress of the concrete in a flip state and a lifting state is analyzed, by comparing with a standard value of axial tensile strength of the concrete, the position and number of anti-crack reinforced steels are analyzed, and cracks are prevented from generating under the common action of the anti-crack reinforced steels and the concrete. During demolding lifting, stress analysis is performed on a solution with or without a balance beam and corresponding three-point and four-point lifting solutions, so as to obtain a component hoisting solution with more uniform stress distribution and smaller concrete damage.

At S3, different application scenarios match the places to be assembled after virtual assembly, and data analysis and optimization are performed on the places to be assembled in different application scenarios.

The application scenarios include application scenarios during practical application after assembly is complete, such as during hospital simulation assembly, in combination with a medical device. By simulating different application scenarios, an assembly structure and medical device placement may be optimized, achieving greater comfort and convenience.

At S4, three-dimensional display is performed on the optimized final assembly solution.

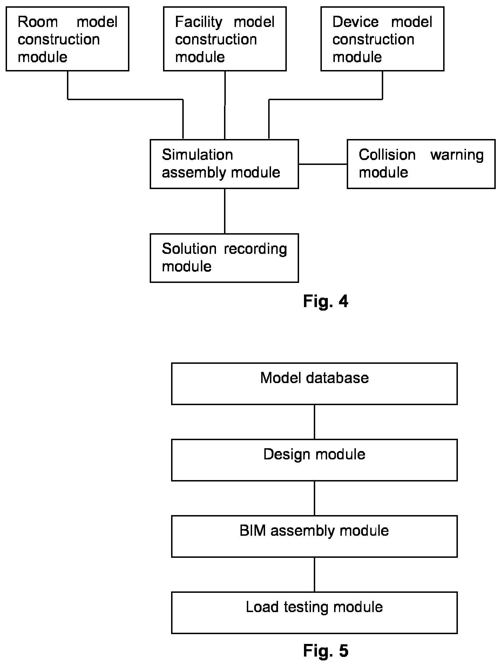

In another optional embodiment of the present disclosure, Fig. 4 is a schematic diagram of a BIM-based prefabricated building design system according to an embodiment of the present disclosure. The system includes a room model construction module, a facility model construction module, a device model construction module, a simulation assembly module, a collision warning module, and a solution recording module. For example, when the system is applied to device simulation assembly in a prefabricated ward, the room model construction module is configured to construct a prefabricated ward region according to design requirements. The facility model construction module is configured to construct various medical facility assembly models. The device model construction module is configured to construct various medical device models. The simulation assembly module is configured to perform simulation assembly on the medical facility models and the medical device models according to a layout of the ward region. The collision warning module is configured to monitor a collision event during simulation assembly of the medical facility models and the medical device models, so as to issue a collision warning. The solution recording module is configured to record a simulation assembly process of the medical facility models and the medical device models, output a final assembly construction solution by reforming the simulation assembly process, and simulate and demonstrate the assembly construction solution.

When the system is applied to simulation assembly of a prefabricated animal laboratory, based on a BIM design, simulation is performed on elements of the laboratory in the BIM design, and collision detection is performed by using BIM; electromechanical pipelines are integrated, and then split into modules that may be rapidly assembled; and the entire mounting process is simulated, processes, tools, personnel assignment, hoisting solutions, and devices are simulated based on an actual mounting flow, and risk evaluation is performed on the mounting process.

When the system is applied to prefabricated electromechanical implementation in public buildings, based on the BIM design, deepening design and comprehensive pipeline arrangement are performed on the public buildings and regions with a high concentration of core surrounding pipelines, so as to split the regions into a plurality of modules, the electromechanical pipelines are integrated and then split into modules that may be rapidly assembled, simulation is performed on elements of electromechanical components in the BIM design model, and collision detection is performed by using the BIM, so as to avoid collision.

The room model construction module mainly includes a room model library and a fixable point marking unit. In this embodiment, a standard ward room model and a function room model are preset in the room model library. A ward room represents a standard layout and structural dimensions of a ward, and includes an ordinary multi-patient ward and a private ward, as well as a general ward and an emergency ward for patient hospitalization. The difference between them lies in that the general ward primarily features hospital beds supplemented by essential medical devices, whereas the emergency ward requires the mounting of more medical devices, including emergency devices, facilities, more workstations, larger operational spaces, etc. The function room model represents a functional room, including an office for medical staff, a medication room, an operating room, and other healthcare spaces, as well as a device and facility room such as an electrical distribution room, a power room, and a functional room for mounting device and facilities. More ward rooms with different structures and dimensions and function rooms with different functions may also be constructed according to actual requirements, and details are not described herein again. However, regardless of the type of rooms, the rooms need to be capable of being assembled into an integrated ward region. Therefore, all the ward room models and function room models use a standardized connection form to ensure normal actions of personnel and the connection and mounting of various facilities and devices.

Further, in this embodiment, the fixable point marking unit is disposed, and is configured to set, on a wall of the ward room model and/or function room model, a mark that may serve as a position for fixed load-bearing and mounting. As described above, different rooms have different functions and also have different structures and dimensions. Although the connection form follows a unified standard, the specific place inside each room that may serve as a load-bearing fixed mounting position is not consistent. In this case, the fixable point marking unit is required to mark, according to the structure, dimension, and function of each room, the position for fixed load-bearing mounting, so as to facilitate subsequent mounting of various medical facilities.

The facility model construction module includes a facility model library, which is provided with a standard facility model and includes essential infrastructure such as water, electricity, and heating systems, various medical gas pipelines and circuits, necessary power devices and pipelines, ventilation systems, etc., which are all belong to medical facilities in this embodiment. In an example of the most common oxygen pipeline and electric power circuit in the ward, along with a corresponding electrical distribution room and oxygen supply room, although standard facility models, which are an oxygen pipeline model (including a pipeline and an essential protective conduit groove) and an electric power circuit model (including the circuit itself and an essential protective conduit sleeve), have already constructed and preset, their lengths, corners, directions, and end points all need to be adjusted accordingly, and corresponding data adjustment is required for each adjustment. Therefore, when the facility models are deployed, parameter data is also adjusted in real time.

Further, precisely because of the adjustment made to various facility models, that is, adjustment during actual mounting, the fixed points for these facilities on the walls during mounting also need to be clearly specified. Therefore, a fixed position marking unit is added and is configured to mark, according to a facility model structure, the position required for mounting and fixing. The marked position needs to meet a fixation requirement of the facility itself, and also needs to correspond to the mark that may serve as a load-bearing fixed mounting position in the room described above, thereby ensuring stable mounting.

The device model construction module includes a medical device model library, in which various medical device models are preset. The medical devices come into various dimensions. A small medical device may directly enter the room for deployment and mounting, and a large medical device may not directly enter the ward due to an excessive size. In this case, an assembly unit may split the medical device model into individual component units according to a specific structure composition of an actual medical device, and assemble the individual component units in the room after the individual component units are transported to the corresponding room. During the transportation process and the assembly process, transportation may be completed first, and then assembly is performed in the room; or a portion may be transported first, a portion is assembled, then a portion is transported, and a portion is assembled, continuing the processes. The specific manner depends on the monitoring result of the collision warning module.

The collision warning monitoring module needs to monitor a collision event during simulation assembly of the medical facility model and the medical device model, issue a collision warning, and also monitors whether a collision event occurs during the transportation process and assembly process of the individual component units. If a collision event occurs, it means that a collision also occurs during actual construction, resulting in damage to rooms, facilities, or devices.

In this embodiment, the collision warning monitoring module decides, by using an Axis-Aligned Bounding Box (AABB) algorithm, whether there is a collision between objects.

The simulation assembly module performs simulation assembly on various medical facility models and various medical device models described above according to the layout of the ward region. The simulation process is fully recorded by the solution recording module.

In this embodiment, the solution recording module includes a recording unit, a reforming unit, an output unit, and a simulation reproduction unit.

Specifically, the recording unit is configured to record simulation assembly processes of the medical facility model and medical device model. The simulation assembly process includes all operation processes, including all processes of modification, deletion, adjustment, etc. Clearly, this process generates numerous unnecessary operations. The reforming unit reforms the simulation assembly process protecting all these operations, including deleting a repeated or modified operation, correcting mounting positions of various medical facility assembly models and medical device models, etc., ultimately presenting a single, smooth mounting flow. Finally, the output unit outputs the reformed final assembly construction solution. Moreover, the simulation reproduction unit simulates and reproduces the mounting process of the entire prefabricated ward and various internal medical facilities and medical devices according to the assembly construction solution, and show the entire assembly construction solution in a visual form of animation simulation, facilitating a correct operation of a worker. If a problem occurs during simulation reproduction, a problem cause or a problem point may also be searched by the recording unit, thereby performing correction.

The embodiments of the present disclosure achieve simulation assembly of the devices in the prefabricated ward by using a BIM technology, thereby improving the accuracy and efficiency of device assembly.

In another optional embodiment of the present disclosure, Fig. 5 is a schematic diagram of a BIM-based prefabricated building design system according to an embodiment of the present disclosure. The system includes a model database, a design module, a BIM assembly module, and a load testing module. In an example of laboratory simulation assembly, the model database is configured to store 3D models of building materials required for constructing a laboratory.

The 3D models include a wall model, a pipeline model, a building power distribution facility model, and a laboratory material model. First, structure parameters of an existing chemical laboratory are collected. Specifically, structures inside the existing laboratory are extracted by using the BIM technology, including wall structure data, pipeline structure and connection data, circuit arrangement data, and laboratory material data; wall material and pipeline material data is simultaneously collected according to a design drawing; and the wall model, the pipeline model, the building power distribution facility model, and the laboratory material model are constructed based on the data. The BIM technology is a building information model technology based on digital modeling, which may efficiently perform design, simulation, and collaboration. Common BIM software includes Revit, Tekla, ArchiCAD, etc.

The design module is configured to design the chemical laboratory.

An operation process of the design module includes: providing a laboratory design platform for a user, performing design on the chemical laboratory according to user requirements, and generating an entire design drawing of the laboratory. When the laboratory is designed, the overall appearance and layout of the laboratory need to be designed first, and then the structures inside the laboratory is further designed. Spaces of the structures inside the laboratory include a plurality of pre-divided spaces divided according to design room types, as well as internal structural parameters of the building. In this embodiment, model space extraction is performed on the building structures in a design phase, and the extracted model spaces are divided according to functionality, so as to obtain the plurality of pre-divided spaces; and then each parameter of each pre-divided space inside the building is extracted to obtain the usage area, wall height and width, positions of doors and windows, and dimensions of the doors and windows of each pre-divided space.

The BIM assembly module is configured to perform simulation assembly by using the 3D models and laboratory design based on the BIM technology.

An operation flow of the BIM assembly module includes: performing simulation assembly by using the 3D models and laboratory design; performing collision detection during the assembly of the 3D models; detecting, according to the positions and dimensions of different building materials and a collision rule, whether there is a collision or conflict between components in the assembled chemical laboratory; and issuing a warning or performing automatic adjustment to ensure the accuracy and rationality of simulation building.

The load testing module is configured to perform a load test on the assembled laboratory model.

An operation flow of the load testing module includes: applying a load to the laboratory model, so as to acquire mechanical data, displacement data, and strain data during testing; updating the laboratory model, according to the mechanical data, displacement data, and strain data, so as to acquire a measured model in an actual state; and merging the laboratory model and the measured model to obtain a digital fusion model, and acquiring a load state during assembly according to the digital fusion model. In this embodiment, structurally-concentrated stress points are selected as observation points in the laboratory model, a virtual loading framework is designed as a bearing platform of the laboratory model, a virtual load-applying apparatus is then disposed on the virtual loading framework, so as to apply a load to the laboratory model; and deciding the feasibility of the assembly solution according to the load state. After a load is applied, the mechanical data and displacement data of the observation points in the laboratory model, as well as the stress data of the load-bearing wall, are collected; update fusion is performed on the model based on the data, so as to obtain the load state of the laboratory model; and the feasibility of the assembly solution for the laboratory is decided according to the load state.

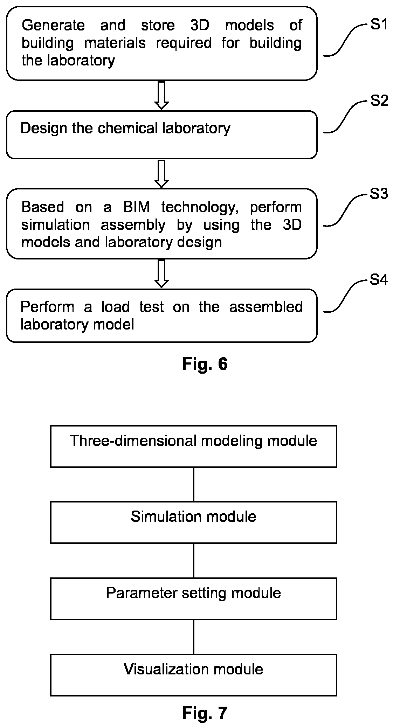

In another optional embodiment of the present disclosure, a BIM-based building simulation assembly method is provided. Fig. 6 is a flowchart of a BIM-based building simulation assembly method according to an embodiment of the present disclosure. In an example of the simulation assembly of the above laboratory, the method includes the following steps.

At S1, 3D models of building materials required for building the laboratory are generated and stored.

The 3D models include a wall model, a pipeline model, a building power distribution facility model, and a laboratory material model. First, structure parameters of an existing chemical laboratory are collected. Specifically, structures inside the existing laboratory are extracted by using the BIM technology, including wall structure data, pipeline structure and connection data, circuit arrangement data, and laboratory material data; wall material and pipeline material data is simultaneously collected according to a design drawing; and the wall model, the pipeline model, the building power distribution facility model, and the laboratory material model are constructed based on the data. The BIM technology is a building information model technology based on digital modeling, which may efficiently perform design, simulation, and collaboration. Common BIM software includes Revit, Tekla, ArchiCAD, etc.

At S2, the chemical laboratory is designed.

S2 includes: a laboratory design platform is provided for a user, design is performed on the chemical laboratory according to user requirements, and an entire design drawing of the laboratory is generated. When the laboratory is designed, the overall appearance and layout of the laboratory need to be designed first, and then the structures inside the laboratory is further designed. Spaces of the structures inside the laboratory include a plurality of pre-divided spaces divided according to design room types, as well as internal structural parameters of the building. In this embodiment, model space extraction is performed on the building structures in a design phase, and the extracted model spaces are divided according to functionality, so as to obtain the plurality of pre-divided spaces; and then each parameter of each pre-divided space inside the building is extracted to obtain the usage area, wall height and width, positions of doors and windows, and dimensions of the doors and windows of each pre-divided space.

At S3, based on the BIM technology, simulation assembly is performed by using the 3D models and laboratory design.

S3 includes: simulation assembly is performed by using the 3D models and laboratory design; collision detection is performed during the assembly of the 3D models; whether there is a collision or conflict between components in the assembled chemical laboratory is detected according to the positions and dimensions of different building materials and a collision rule; and a warning is issued or automatic adjustment is performed to ensure the accuracy and rationality of simulation building.

At S4, a load test is performed on the assembled laboratory model.

S4 includes: a load is applied to the laboratory model, so as to acquire mechanical data, displacement data, and strain data during testing; the laboratory model is updated according to the mechanical data, displacement data, and strain data, so as to acquire a measured model in an actual state; and the laboratory model and the measured model are merged to obtain a digital fusion model, and a load state during assembly is acquired according to the digital fusion model. In this embodiment, structurally-concentrated stress points are selected as observation points in the laboratory model, a virtual loading framework is designed as a bearing platform of the laboratory model, a virtual load-applying apparatus is then disposed on the virtual loading framework, so as to apply a load to the laboratory model; and deciding the feasibility of the assembly solution according to the load state. After a load is applied, the mechanical data and displacement data of the observation points in the laboratory model, as well as the stress data of the load-bearing wall, are collected; update fusion is performed on the model based on the data, so as to obtain the load state of the laboratory model; and the feasibility of the assembly solution for the laboratory is decided according to the load state.

In another optional embodiment of the present disclosure, Fig. 7 is a schematic diagram of a BIM-based prefabricated building design system according to an embodiment of the present disclosure. The system includes a pipeline mounting simulation system, so as to achieve pipeline mounting simulation. The pipeline mounting simulation system includes a three-dimensional modeling module, a simulation module, a parameter setting module, and a visualization module. The three-dimensional modeling module is configured to create and edit a pipeline information model by using BIM software; the simulation module is configured to simulate a pipeline mounting process based on the pipeline information model; the parameter setting module is configured to set a pipeline parameter during pipeline mounting; and the visualization module is configured to display a simulation result.

The simulation module includes a resource scheduling unit and a collision detection unit. The resource scheduling unit is configured to perform resource scheduling during pipeline mounting; and the collision detection unit is configured to perform collision detection during pipeline mounting, and generate a collision report. The collision detection unit detects, by using the AABB algorithm, whether there is a collision during mounting.

The pipeline parameter includes a pipeline attribute and a mounting parameter. The parameter setting module includes a pipeline parameter unit and a mounting parameter unit. The pipeline parameter unit is configured to set the pipeline attribute, including a pipeline diameter, a wall thickness, and a material. The mounting parameter unit is configured to set the mounting parameter, including a mounting sequence, a mounting manner, and a mounting time.

The visualization module includes a report generation unit and a three-dimensional visualization unit. The report generation unit is configured to generate a chart report during simulation and mounting. The three-dimensional visualization unit is configured to display the simulation process and result in a three-dimensional form.

How to solve the technical problem in real life by the present disclosure is described in detail below with reference to this embodiment.

First, the three-dimensional modeling module creates and edits a pipeline information model by using BIM software.

The pipeline information model is created and edited in a simulation environment by using the BIM technology. The BIM technology is a information model technology based on digital modeling, which may efficiently perform design, simulation, and collaboration. Common BIM software includes Revit, Tekla, ArchiCAD, etc. The user may import the drawing and design requirements of the pipeline structure in the BIM software, and perform three-dimensional modeling to generate pipeline information in the simulation environment.

Then, the simulation module simulates the pipeline mounting process based on the pipeline information model, including routing, connection, and mounting of pipelines. During simulation, the user uses the resource scheduling module to perform resource scheduling and allocation according to pipeline mounting requirements and resource situations.

After simulation mounting is completed, the collision detection unit is used to detect whether there is a collision. Detailed flow includes the following.

1. Collision body definition: during simulation, one collision body needs to be defined for each object to describe the shape and size of the object. The collision body may be a simple geometric shape such as a rectangle, a circle, and a polygon, or may also be a complex object surface. A collision relationship between the objects may be determined by defining the collision body.

2. Collision detection algorithm: the collision detection algorithm is a core portion of the collision detection unit and is configured to decide whether there is a collision between two or more objects. This embodiment uses the AABB algorithm to decide whether there is a collision between the objects.

3. Collision response: when a collision between the objects is detected, the collision detection unit needs to calculate a collision response between the objects, that is, a motion state after the object after collision. Speed and direction changes in the object after collision may be calculated according to physical attributes (e.g., mass, elasticity coefficient, etc.) of the object. The calculation of the collision response may ensure that the simulation process meets an actual situation.

4. Collision report: during pipeline mounting simulation, the collision detection unit generates a collision report to record a collision situation between the pipeline and other elements. The collision report may include information such as a position of a collision, an ID of a collision object, a motion state after collision, etc. By analyzing the collision report, potential problems during mounting may be found, thereby optimizing the pipeline mounting solution.

Specifically, the above flow of using the AABB algorithm to perform collision detection includes the following operation.

Minimum and maximum boundaries of the pipeline on an x-axis, a y-axis, and a z-axis are calculated. Generally, the boundaries of the pipeline may be indicated by vectors including a minimum value and a maximum value. For example, a boundary of a rectangular object on the x-axis may be indicated by (minx, maxx), and a boundary on a y-axis may be indicated by (miny, maxy). During pipeline mounting, the boundaries of elements surrounding the pipeline on the x-axis, y-axis, and z-axis (if applicable) are calculated respectively. Whether the pipeline and the surrounding elements overlap on each axis is decided. For each axis, if a distance between the minimum boundaries of two objects is greater than or equal to a distance between the respective maximum boundaries of the two objects, the two objects do not overlap on the axis. Otherwise, the two objects overlap on the axis. If the two rectangular objects overlap on all axes, there is a collision between the objects. Otherwise, no collision occurs between the objects. Furthermore, in order to improve the accuracy of detection, an SAT detection algorithm may also be added to improve the accuracy of collision detection.

The parameter setting module is used to set the pipeline parameters during pipeline mounting, such as a pipeline type, a mounting sequence, a mounting time, etc. Specifically, the pipeline parameter unit is used to set the attribute and specification of the pipeline, such as a pipeline diameter, a wall thickness, a material, etc. The mounting parameter unit is used to set the pipeline parameter, such as a mounting sequence, a mounting manner, a mounting time, etc.

Finally, the visualization module is used to display the simulation result, including the pipeline mounting process and result.

The report generation unit shows the mounting report in a visual manner such as a chart, and generates a report chart to show collision situations, resource scheduling, mounting time, etc. during pipeline mounting.

In this embodiment, the three-dimensional visualization unit may also combine the simulation result with the pipeline model to intuitively display the collision situations, render colors of different portions in the pipeline model, and use different colors to indicate different collision situations.

In another optional embodiment of the present disclosure, a BIM-based mounting simulation method is provided and includes the following steps.

At S1, a pipeline information model is created and edited by using BIM software.

The pipeline information model is created and edited in a simulation environment by using the BIM technology. The BIM technology is a information model technology based on digital modeling, which may efficiently perform design, simulation, and collaboration. Common BIM software includes Revit, Tekla, ArchiCAD, etc. The user may import the drawing and design requirements of the pipeline structure in the BIM software, and perform three-dimensional modeling to generate pipeline information in the simulation environment.

At S2, a pipeline mounting process is simulated based on the pipeline information model.

Routing, connection, and mounting of pipelines are included. During simulation, resource scheduling and allocation are performed according to pipeline mounting requirements and resource situations.

After simulation mounting is completed, whether there is a collision is detected. Detailed flow includes the following.

1. Collision body definition: during simulation, one collision body needs to be defined for each object to describe the shape and size of the object. The collision body may be a simple geometric shape such as a rectangle, a circle, and a polygon, or may also be a complex object surface. A collision relationship between the objects may be determined by defining the collision body.

2. Collision detection algorithm: the collision detection algorithm is a core portion of the collision detection unit and is configured to decide whether there is a collision between two or more objects. This embodiment uses the AABB algorithm to decide whether there is a collision between the objects.

3. Collision response: when a collision between the objects is detected, the collision detection unit needs to calculate a collision response between the objects, that is, a motion state after the object after collision. Speed and direction changes in the object after collision may be calculated according to physical attributes (e.g., mass, elasticity coefficient, etc.) of the object. The calculation of the collision response may ensure that the simulation process meets an actual situation.

4. Collision report: during pipeline mounting simulation, the collision detection unit generates a collision report to record a collision situation between the pipeline and other elements. The collision report may include information such as a position of a collision, an ID of a collision object, a motion state after collision, etc. By analyzing the collision report, potential problems during mounting may be found, thereby optimizing the pipeline mounting solution.

Specifically, the above step of using the AABB algorithm to perform collision detection includes the following operation.

Minimum and maximum boundaries of the pipeline on an x-axis, a y-axis, and a z-axis are calculated. Generally, the boundaries of the pipeline may be indicated by vectors including a minimum value and a maximum value. For example, a boundary of a rectangular object on the x-axis may be indicated by (minx, maxx), and a boundary on a y-axis may be indicated by (miny, maxy). During pipeline mounting, the boundaries of elements surrounding the pipeline on the x-axis, y-axis, and z-axis (if applicable) are calculated respectively. Whether the pipeline and the surrounding elements overlap on each axis is decided. For each axis, if a distance between the minimum boundaries of two objects is greater than or equal to a distance between the respective maximum boundaries of the two objects, the two objects do not overlap on the axis. Otherwise, the two objects overlap on the axis. If the two rectangular objects overlap on all axes, there is a collision between the objects. Otherwise, no collision occurs between the objects. Furthermore, in order to improve the accuracy of detection, an SAT detection algorithm may also be added to improve the accuracy of collision detection.

At S3, a pipeline parameter is set during pipeline mounting.

The pipeline parameter includes a pipeline attribute and a mounting parameter. The parameter setting module includes a pipeline parameter unit and a mounting parameter unit. The pipeline parameter unit is configured to set the pipeline attribute, including a pipeline diameter, a wall thickness, and a material. The mounting parameter unit is configured to set the mounting parameter, including a mounting sequence, a mounting manner, and a mounting time.

At S4, a simulation result is displayed by means of visualization.

A mounting report is displayed in a visual manner such as a chart, and a report chart is generated to show collision situations, resource scheduling, mounting time, etc. during pipeline mounting. In this embodiment, the simulation result may also be combined with the pipeline model to intuitively display the collision situations, colors of different portions in the pipeline model are rendered, and different colors are used to indicate different collision situations.

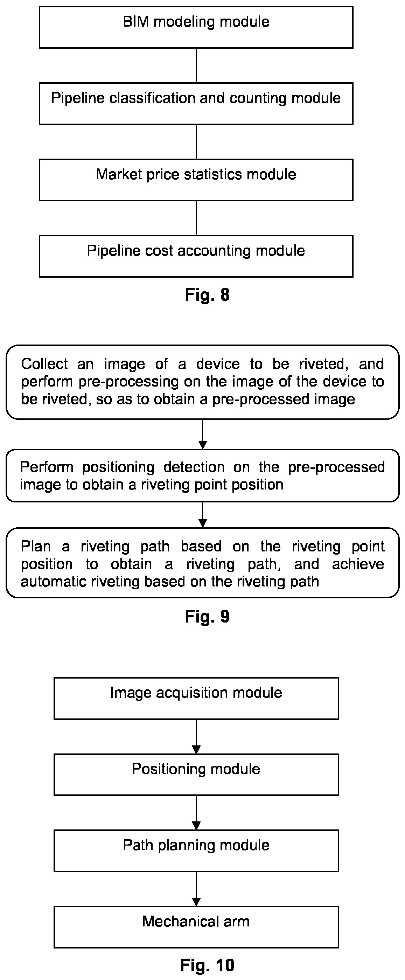

In another optional embodiment of the present disclosure, Fig. 8 is a schematic diagram of a BIM-based prefabricated building design system according to an embodiment of the present disclosure. The system is configured to perform cost accounting for pipeline mounting. The system includes a BIM modeling module, a pipeline classification and counting module, a market price statistics module, and a pipeline cost accounting module.

The BIM modeling module is configured to perform three-dimensional modeling based on a construction drawing, so as to generate a three-dimensional model.

The pipeline classification and counting module is configured to classify pipelines in the three-dimensional model, and mark and count each category of pipelines, respectively, so as to obtain the number of different types of pipelines.

The market price statistics module is configured to perform statistics on the price and quality of pipelines in the market.

The pipeline cost accounting module is configured to perform solution generation according to the price and quality of pipelines in the market and the number of different types of pipelines, so as to obtain different pipeline mounting solutions, and perform cost accounting on the pipeline mounting solutions.

The BIM modeling module includes a point cloud scanning sub-module, a point cloud pre-processing sub-module, a pipeline extraction sub-module, and a model construction sub-module.

The point cloud scanning sub-module is configured to scan a construction drawing by using SL-100D, so as to acquire point cloud data of a building.

The point cloud pre-processing sub-module is configured to perform pre-processing of format conversion, data fusion, redundancy removal, point cloud coloring, and point cloud segmentation on the point cloud data.

Uniform division is performed according to a geometric shape during point cloud segmentation: point cloud is divided into superpoints, the point cloud is inputted without supervision, and a superpoint diagram is obtained after point cloud partitioning. Each node of the superpoint diagram corresponds to a small piece of the entire point cloud, and a basic unit of the geometric shape also corresponds to this. The nodes are segmented by using the boundary characteristics of the superpoints and a deep learning algorithm for graph convolution.

The pipeline extraction sub-module is configured to perform pipeline extraction on pre-processed point cloud.

The model construction sub-module is configured to generate a two-dimensional pipeline distribution diagram based on an extracted pipeline and the pre-processed point cloud, and construct a BIM three-dimensional model of the pipeline distribution diagram by using Revit software.

The pipeline classification and counting module further includes a pipeline classification sub-module and a pipeline counting sub-module.

The pipeline classification sub-module is configured to perform pipeline classification according to different types of coloring based on a point cloud coloring effect in the point cloud pre-processing sub-module.

The pipeline counting sub-module is configured to count the number of pipelines based on pipeline point cloud coloring in the pipeline classification sub-module.

Counting the number of pipelines based on pipeline point cloud coloring in the pipeline classification sub-module specifically includes the following operations.

A picture for pipeline point cloud coloring is acquired, and the picture is divided into PR, PG, and PB pictures according to three primary colors.

The PR, PG, and PB pictures are adjusted to filter a lower limit of a color value of the background to remove background and noise of the pictures, so as to obtain de-noised images with the same size with the pictures.

Grayscale conversion is performed on the de-noised images, and edges of grayscale images are blurred through Gaussian filtering, so as to obtain filtered de-noised images.

Erosion expansion is performed on the filtered de-noised images, and then an external contour of a pipeline is detected through an edge tracking algorithm, so as to acquire external contours of N pipelines in the grayscale images, where $N \geq 1$.

All pixel points of the external contours of the pipelines are constituted based on the external contour of each pipeline, whether a gradient of each pixel point is the largest among surrounding pixel points with a same gradient direction is decided, and if so, a current pixel point is reserved, otherwise the current pixel point is removed.

Whether the number of pixel points of the external contour of the current pipeline is less than a set threshold is decided, and the pixel points of the external contour of the current pipeline are extracted, so as to filter external contours of M pipelines among the external contours of the N pipelines, where $1 \leq M \leq N$.

A convex hull function is further used on the screened external contours of the M pipelines to obtain each pixel point forming the contour around the entire pipeline, so as to obtain the accurate external contours of the M pipelines.

The number of pipelines is obtained according to the number of the external contours.

The market price statistics module includes an object positioning sub-module, a matching and supplementation sub-module, and a pipeline-related data sub-module.

The object positioning sub-module is configured to position commodities similar to the pipelines in the market.

The matching and supplementation sub-module is configured to supplementing the similar commodity by combining a fuzzy matching method.

The pipeline-related data sub-module is configured to acquire the pipeline commodities and related data of products similar to the pipelines according to the supplemented similar commodities.

Positioning the commodities similar to the pipelines in the market specifically includes the following operations.

A clustering algorithm is used to position a similar product.

Characteristic attributes of the pipelines are manually labeled.

Searchable approximate corpora similar to the pipelines is manually labeled.

A similarity search language model is established based on a natural language processing technology and the approximate corpora.

The commodities similar to the pipelines are clustered based on a semi-supervised natural language processing technology and the similarity search language model.

The basic information of the pipelines in the market is obtained after clustering is completed, commodities obtained through searching are analyzed, and keyword matching is performed on details in commodity information obtained through searching. All pipeline information related to the pipelines is obtained through searching in real time.

The pipeline cost accounting module further includes a mounting solution generation sub-module and a solution cost accounting sub-module.

The solution generation sub-module is configured to formulate a mounting solution based on the number of various pipelines and pipeline market price.

The solution cost accounting sub-module is configured to perform cost accounting of the mounting solution based on the mounting solution.

Formulating the mounting solution based on the number of various pipelines and the pipeline market price specifically includes the following operations.

Pipeline correction is performed according to the length, type, and material of the required pipeline.

A genetic algorithm is used for the corrected pipeline to obtain a comprehensive mounting result, and the pipeline mounting solution is generated according to the comprehensive mounting result.

When the mounting solution is specified, the selected pipeline is obtained through query based on an interaction operation and structural data. A query condition is encoded by using a system architecture of product-function-model-material-price.

In another optional embodiment of the present disclosure, a BIM-based prefabricated building simulation assembly method is provided and includes the following steps.

At S1, data information of a building to be assembled is collected, and the data information is analyzed.

At S2, a BIM model of a prefabricated building is constructed according to the data information.

At S3, a building component drawing is exported according to the BIM model.

At S4, assembly path planning is performed on a manufactured building component, and assembly is performed based on a planned path.

In another optional embodiment of the present disclosure, as shown in Fig. 9, an automatic riveting method is provided and configured to plan a riveting path and perform automatic riveting according to the planned riveting path. The method includes the following steps.

An image of a device to be riveted is collected, and pre-processing is performed on the image of the device to be riveted, so as to obtain a pre-processed image.

Positioning detection is performed on the pre-processed image to obtain a riveting point position.

Riveting path planning is performed based on the riveting point position, so as to obtain a riveting path, and automatic riveting is realized based on the riveting path.

In this embodiment, the method for obtaining the pre-processed image includes the following operations.

De-noising processing is performed, by using a dual-domain image denoising method, on the image of the device to be riveted, so as to obtain a de-noised image.

Image enhancement processing is performed on the de-noised image through piecewise linear transformation, so as to obtain an enhanced image.

Edge detection is performed on the enhanced image to obtain the pre-processed image.

In this embodiment, the method for obtaining the de-noised image includes the following operation.

A spatial domain method is used to perform preliminary de-noising on the image. A common spatial domain filter technology may also be included, such as mean filtering, median filtering or Gaussian filtering. These methods may effectively reduce some high-frequency noise in the image. The image is converted into a frequency domain, and Fourier transform is generally used. The frequency domain indicates frequency information that may help to analyze the image, facilitating understanding of noise characteristics. In the frequency domain, noise may be further removed through filtering or other frequency domain technologies. A common frequency domain filter method includes using a low-pass filter such as a Gaussian low-pass filter, so as to reserve low-frequency information of the image while removing the high-frequency noise. According to a specific situation, parameters of a de-noising algorithm are adjusted to obtain an optimal effect. The method may further include adjusting the size of the filter, parameters of the frequency domain filter, etc. The processed image is converted back to the spatial domain from the frequency domain, so as to obtain a final de-noised image.

In this embodiment, the method for enhancing image includes the following operation.

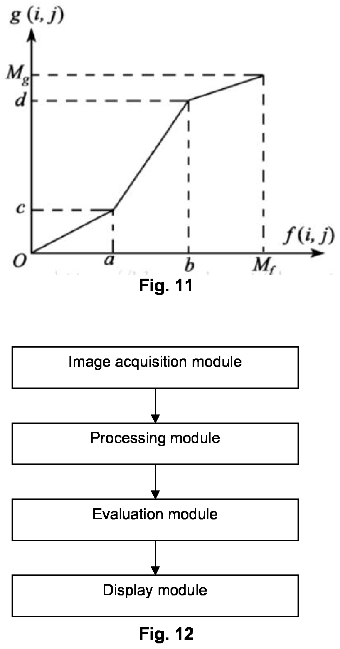

As shown in Fig. 11, an original image f(x, y) is set to [0, Mf], a grayscale range of a target of interest is set to [a, b], and if its grayscale range is about to be extended to [c, d], a corresponding piecewise linear transformation expression is as follows.

$$g(x,y) = \begin{cases} (c/a)f(x,y) & 0 \le f(x,y) < a \\ [(d-c)/(b-a)][f(x,y)-a]+c & a \le f(x,y) < b \\ [(M_g-d)/(M_f-b)][f(x,y)-b]+d & b \le f(x,y) \le M_f \end{cases}.$$

In this embodiment, the method for performing edge detection includes the following operation.

The enhanced image is converted into a grayscale image, and the image is smoothed by using a smoothing filter (e.g., a Gaussian filter). Smoothing facilitates a reduction in noise in the image, causing an edge detection result to be stabler. A Laplace kernel (convolution kernel) is defined and generally configured to highlight an edge in the image. The convolution kernel is as follows.

$$[0 \ -1 \ 0]$$

$$[-1 \ 4 \ -1]$$

$$[0 \ -1 \ 0].$$

The selected Laplace kernel is used to perform a convolution operation on the image. In each pixel position of the image, a multiplication operation is performed on the convolution kernel and a corresponding region of the image, and then the results are added to obtain a pixel value after convolution. Threshold processing is performed on the convolution result to highlight the edge. A pixel of which edge response exceeds a threshold is marked as the edge. According to the result of threshold processing, the edge in the image is marked white, and other regions are marked as black.

In this embodiment, the method for obtaining the riveting point position includes the following operation.

A riveting point image is acquired, a feature extraction model is constructed based on a VGG19 network, the riveting point image is inputted to the feature extraction model to obtain a riveting point feature, a riveting point identification model is constructed based on the riveting point feature, the pre-processed image is inputted in the riveting point identification model to obtain a riveting point in the pre-processed image, a coordinate system of the pre-processed image is constructed, and the riveting point position is determined based on the coordinate system.

The feature extraction model is constructed without using a fully connected layer by using 16 convolution layers and 5 pooling layers of the VGG19 network.

In this embodiment, the method for obtaining the riveting path includes the following operation.

The riveting point closest to a rivet is used as a start riveting point, the point closest to the start riveting point is used as a next riveting point, and so on, until riveting is completed.

As shown in Fig. 10, the present disclosure provides an automatic riveting system, including an image acquisition module, a positioning module, a path planning module, and a mechanical arm.

The image acquisition module is configured to collect an image of a device to be riveted, and perform pre-processing on the image of the device to be riveted, so as to obtain a pre-processed image.

The positioning module is connected to the image acquisition module, and is configured to perform positioning detection on the pre-processed image to obtain a riveting point position.

The path planning module is connected to the positioning module, and is configured to plan a riveting path based on the riveting point position.

The mechanical arm is connected to the path planning module, and is configured to perform automatic riveting based on the riveting path and the riveting point position.

In this embodiment, the image acquisition module includes a photographing unit and a pre-processing unit.

The photographing unit is configured to photograph the image of the device to be riveted.

The pre-processing unit is configured to perform image enhancement processing on the image of the device to be riveted.

In this embodiment, the pre-processing unit includes a de-noising sub-unit, an image enhancement sub-unit, and an edge detection sub-unit.

The de-noising sub-unit is configured to perform, by using a dual-domain image denoising method, de-noising processing on the image of the device to be riveted, so as to obtain a de-noised image.

The image enhancement sub-unit is configured to perform image enhancement processing on the de-noised image through piecewise linear transformation, so as to obtain an enhanced image.

The edge detection sub-unit is configured to perform edge detection on the enhanced image to obtain a pre-processed image.

In this embodiment, the positioning module includes a clipping unit, a model construction unit, and a coordinate system construction unit.

The clipping unit is configured to clip the pre-processed image to obtain a riveting point image.

The model construction unit is configured to construct a riveting point identification model based on the riveting point image.

The coordinate system construction unit is configured to construct a coordinate system of the pre-processed image.

In another optional embodiment of the present disclosure, a riveting appearance evaluation method is provided to solve the problems of low detection speed and detection efficiency of artificial visual detection of riveting quality in the related art, high manual costs, artificial visual detection struggling to quickly detect certain minute appearance defects, and incapability of ensuring the consistency of the detection result due to impact of subjective factors. The method includes the following operation.

A riveting point image is collected by a calibrated camera, and pre-processing is performed on the riveting point image to obtain a processed image.

In a preferred implementation, an angle of view and distance of an image acquisition device are calculated according to a riveting point type; the image acquisition device is arranged according to the angle of view and distance, and the camera is calibrated; the riveting point image after a riveting process is completed is collected; and the riveting point image is numbered, an image acquisition time is extracted, and associative storage is performed with the riveting point image.

In a preferred implementation, the pre-processing process includes: the riveting point image is smoothed, and then the image is decomposed to remove noise through wavelet transform, so as to obtain a reconstructed image; grayscale processing is performed on the reconstructed image to obtain a grayscale image, binarization is performed on the grayscale image to obtain a binary image, and a contour combination in the riveting point image is acquired by using a contour finding algorithm; and standard contour information is acquired according to the riveting point number, the contour combination is screened based on the standard contour information to acquire a screened contour combination, and a minimum external rectangle of the screened contour combination is acquired as the processed image.

A convolutional neural network model is constructed, and is trained by a sample data set, so as to obtain a riveting appearance analysis model.

In a preferred implementation, the convolutional neural network model is constructed, and a convolutional neural network is improved by an attention mechanism; a standard riveting point image and a misprinted image are acquired to constitute the sample data set, data augmentation processing is performed, and the improved convolutional neural network model is trained by using the processed sample data set, so as to obtain the riveting appearance analysis model; and an evaluation result is obtained according to the processed image and the riveting appearance analysis model.

The processed image is inputted in the riveting appearance analysis model to obtain feature information; riveting appearance is evaluated based on the feature information; and the evaluation result and the riveting point image are displayed.

In a preferred implementation, the process of obtaining the evaluation result includes: the processed image is inputted in the riveting appearance analysis model to obtain the feature information, principal component analysis is performed on the feature information to obtain an important feature set, where the feature information includes an abnormal feature value; and an abnormal type is decided according to the abnormal feature value, and a qualification degree of the riveting point is determined by the proportion of the abnormal value in the important feature set.

As shown in Fig. 12, this embodiment provides a riveting appearance evaluation system, including: an image acquisition module, a processing module, an evaluation module, and a display module.

The image acquisition module is configured to perform image acquisition on a riveting point to obtain a riveting point image.

In some embodiments, the image acquisition module includes a first acquisition unit and a second acquisition unit.

The first acquisition unit is configured to calculate an angle of view and distance of an image acquisition device according to a riveting point type, arrange the image acquisition device according to the angle of view and distance, and calibrate the camera.

The second acquisition unit is configured to collect the riveting point image after a riveting process is completed, transmit same to the processing module, number the riveting point image, extract an image acquisition time, and perform associative storage with the riveting point image.

The processing module is configured to perform pre-processing on the riveting point image to obtain a processed image.

In some embodiments, the processing module includes a first pre-processing unit, a second pre-processing unit, and a third pre-processing unit.

The first pre-processing unit is configured to smooth the riveting point image, and then decompose the image to remove noise through wavelet transform, so as to obtain a reconstructed image.

The second pre-processing unit is configured to perform grayscale processing on the reconstructed image to obtain a grayscale image, perform binarization on the grayscale image to obtain a binary image, and acquire a contour combination in the riveting point image by using a contour finding algorithm.

The third pre-processing unit is configured to acquire standard contour information according to the riveting point number, screen the contour combination based on the standard contour information to acquire a screened contour combination, and acquire a minimum external rectangle of the screened contour combination as the processed image.

The evaluation module is configured to construct and train a convolutional neural network model to obtain a riveting appearance analysis model, input the processed image in the riveting appearance analysis model to obtain feature information, and evaluate riveting appearance based on the feature information.

In some embodiments, the evaluation module includes a first unit, a second unit, and a third unit.

The first unit is configured to construct the convolutional neural network model, and improve a convolutional neural network by an attention mechanism.

The second unit is configured to acquire a standard riveting point image and a misprinted image to constitute the sample data set, perform data augmentation processing, and train the improved convolutional neural network model by using the processed sample data set, so as to obtain the riveting appearance analysis model.

The third unit is configured to obtain the evaluation result according to the processed image and the riveting appearance analysis model.

In some embodiments, the third unit includes a feature extraction unit and an evaluation unit.

The feature extraction unit is configured to input the processed image in the riveting appearance analysis model to obtain the feature information, perform principal component analysis on the feature information to obtain an important feature set, where the feature information includes an abnormal feature value.

The evaluation unit is configured to decide an abnormal type according to the abnormal feature value, and determine a qualification degree of the riveting point by the proportion of the abnormal value in the important feature set.

The display module is configured to display the riveting point image and the evaluation result.

In the embodiments of the present disclosure, riveting appearance is evaluated based on machine vision, so as to achieve high-precision automated riveting appearance detection, thereby improving the efficiency and accuracy of riveting appearance detection.

The above are only the preferred embodiments of the present disclosure and are not intended to limit the present disclosure. For those skilled in the art, the present disclosure may have various modifications and variations. Any modifications, equivalent replacements, improvements and the like made within the spirit and principle of the present disclosure shall fall within the scope of protection of the present disclosure.

**Claims**

1. A BIM-based prefabricated building design system, comprising: a data acquisition module, a BIM modeling module, a drawing generation module, a component processing module, an assembly module, and a verification module, wherein

   the data acquisition module is configured to collect data information of a prefabricated building;
   the BIM modeling module is configured to construct a BIM model of the prefabricated building according to the data information;
   the drawing generation module is configured to export a building component drawing according to the BIM model;
   the component processing module is configured to perform production manufacturing according to the building component drawing;
   the assembly module is configured to perform assembly path planning on a manufactured building component, and perform assembly based on a planned path; and
the verification module is configured to verify an assembled building.

2. The BIM-based prefabricated building design system as claimed in claim 1, wherein the data acquisition module comprises a design unit, a screening unit, and a data conversion unit;
the design unit is configured to perform simulation analysis on a site and an environment, build a mass model by a designer, and generate a design solution of the prefabricated building; the screening unit is configured to build an analysis model on the basis of the block model to perform simulation analysis, perform solution comparison by analyzing data and comprehensive factors, and estimate a structure form selection to determine an optimal solution; and the data conversion unit is configured to convert the optimal solution into data information for constructing the BIM model of the prefabricated building.

3. The BIM-based prefabricated building design system as claimed in claim 1, wherein the BIM modeling module comprises a construction unit, a fusion unit, a creation unit, and a detection unit;
the construction unit is configured to construct an initial building BIM model and an initial structural BIM model according to the data information of the prefabricated building; the fusion unit is configured to fuse the initial building BIM model and the initial structural BIM model to acquire an integrated BIM model; the creation unit is configured to create a prefabricated BIM model according to the integrated BIM model; and the detection unit is configured to detect the prefabricated BIM model according to the integrated BIM model, and modify the prefabricated BIM model according to a detection result, in a case where there is a difference between the two models, so as to obtain the final BIM model.

4. The BIM-based prefabricated building design system as claimed in claim 1, wherein the drawing generation module comprises a setting unit, a classification unit, and a storage unit;
the setting unit is configured to delete basic information in the BIM model, reserve component names and corresponding dimension data, and export the corresponding building component drawing; the classification unit is configured to classify the building component drawings; and the storage unit is configured to store the exported building component drawing.

5. The BIM-based prefabricated building design system as claimed in claim 1, wherein the component processing module monitors the processing of a building component by using a processing plant according to the exported building component drawing.

6. The BIM-based prefabricated building design system as claimed in claim 1, wherein the assembly module comprises an image acquisition unit, an analysis unit, a control unit, and a monitoring unit;
the image acquisition unit is configured to collect image data of a construction site; the analysis unit is configured to analyze the image data to acquire an optimal assembly path; the control unit is configured to control an assembly process of a building component according to the optimal assembly path; and the monitoring unit is configured to acquire a real-time image of the assembly process, and monitor whether the building component in the real-time image is assembled according to the planned optimal assembly path.

7. The BIM-based prefabricated building design system as claimed in claim 6, wherein a deep learning model constituted by using a CNN and a T2FNN in the analysis unit is configured to analyze real-time image data of a prefabricated building hoisting construction site acquired by the image acquisition unit, find an obstacle affecting prefabricated building hoisting, determine an obstacle position through a raster table, and find an optimal assembly path of a prefabricated part of the prefabricated building through an ant colony algorithm; and send the optimal assembly path of the prefabricated construction to the control unit.

8. The BIM-based prefabricated building design system as claimed in claim 1, wherein the verification module comprises a graphics acquisition unit, a comparison unit, and a reassembly unit;
the graphics acquisition unit is configured to acquire laser scanning data after building assembly, and construct a real-time assembly model of a building based on the laser scanning data; the comparison unit is configured to perform matching degree comparison on the real-time assembly model and the BIM model constructed by the BIM modeling module; and the real-time assembly model is configured to identify an assembly error according to a comparison result, and reassemble an error region according to the BIM model after identifying the assembly error.

9. The BIM-based prefabricated building design system as claimed in claim 1, further comprising: a construction simulation module, a scenario simulation module, and a three-dimensional display module, wherein

the construction simulation module is connected to the data acquisition module and configured to perform component simulation and construction simulation based on the data information of the prefabricated building to obtain a simulation result; the scenario simulation module is connected to the construction simulation module and configured to simulate the simulation result in different scenarios; and the three-dimensional display module is configured to perform three-dimensional display on a construction simulation process and the simulation result.

10. The BIM-based prefabricated building design system as claimed in claim 9, wherein the construction simulation module comprises an analysis unit, a component unit, a construction unit, and a warning unit;
the analysis unit is configured to construct a component based on the data information of the prefabricated building, so as to obtain component data; the component data comprises a component shape and the number of the corresponding components; the construction unit is configured to generate a simulation component based on the component data; the construction unit is configured to perform construction simulation based on the simulation component; and the warning unit is configured to issue a warning for a dangerous event occurring during construction simulation.

11. The BIM-based prefabricated building design system as claimed in claim 1, further comprising a collision warning module and a solution recording module, wherein

the collision warning module is configured to monitor a collision event during simulation assembly, so as to issue a collision warning; and
the solution recording module is configured to record an assembly process, output a final assembly construction solution by reforming the simulation assembly process, and simulate and demonstrate the assembly construction solution.

12. The BIM-based prefabricated building design system as claimed in claim 1, further comprising a model database and a load testing module, wherein

the model database is configured to store 3D models of building materials required for constructing a laboratory; and
the load testing module is configured to perform a load test on an assembled building model.

13. The BIM-based prefabricated building design system as claimed in claim 1, further comprising a pipeline mounting simulation system, wherein the pipeline mounting simulation system comprises a three-dimensional modeling module, a simulation module, a parameter setting module, and a visualization module;

the three-dimensional modeling module is configured to create and edit a pipeline information model by using BIM software;
the simulation module is configured to simulate a pipeline mounting process based on the pipeline information model;
the parameter setting module is configured to set a pipeline parameter during pipeline mounting; and
the visualization module is configured to display a simulation result.

14. The BIM-based prefabricated building design system as claimed in claim 13, wherein the pipeline mounting simulation system further comprises a pipeline classification and counting module, a market price statistics module, and a pipeline cost accounting module;

the pipeline classification and counting module is configured to classify pipelines in the pipeline information model, and mark and count each category of pipelines, respectively, so as to obtain the number of different types of pipelines;
the market price statistics module is configured to perform statistics on the price and quality of pipelines in the market; and
the pipeline cost accounting module is configured to perform solution generation according to the price and quality of pipelines in the market and the number of different types of pipelines, so as to obtain different pipeline mounting solutions, and perform cost accounting on the pipeline mounting solutions.

15. The BIM-based prefabricated building design system as claimed in claim 13, wherein the three-dimensional modeling module comprises a point cloud scanning sub-module, a point cloud pre-processing sub-module, a pipeline extraction sub-module, and a model construction sub-module;

the point cloud scanning sub-module is configured to scan a construction drawing by using SL-100D, so as to acquire point cloud data of a building;

the point cloud pre-processing sub-module is configured to perform pre-processing of format conversion, data fusion, redundancy removal, point cloud coloring, and point cloud segmentation on the point cloud data;

the pipeline extraction sub-module is configured to perform pipeline extraction on pre-processed point cloud; and the model construction sub-module is configured to generate a two-dimensional pipeline distribution diagram based on an extracted pipeline and the pre-processed point cloud, and construct a BIM three-dimensional model of the pipeline distribution diagram by using Revit software.

16. The BIM-based prefabricated building design system as claimed in claim 14, wherein the pipeline classification and counting module further comprises a pipeline classification sub-module and a pipeline counting sub-module;

the pipeline classification sub-module is configured to perform pipeline classification according to different types of coloring based on a point cloud coloring effect in the point cloud pre-processing sub-module; and

the pipeline counting sub-module is configured to count the number of pipelines based on pipeline point cloud coloring in the pipeline classification sub-module.

17. The BIM-based prefabricated building design system as claimed in claim 16, wherein counting the number of pipelines based on pipeline point cloud coloring in the pipeline classification sub-module specifically comprises:

acquiring a picture for pipeline point cloud coloring, and dividing the picture into PR, PG, and PB pictures according to three primary colors;

adjusting the PR, PG, and PB pictures to filter a lower limit of a color value of the background to remove background and noise of the pictures, so as to obtain de-noised images with the same size with the pictures;

performing grayscale conversion on the de-noised images, and blurring edges of grayscale images through Gaussian filtering, so as to obtain filtered de-noised images;

performing erosion expansion on the filtered de-noised images, and then detecting an external contour of a pipeline through an edge tracking algorithm, so as to acquire external contours of N pipelines in the grayscale images, wherein $N \geq 1$;

constituting all pixel points of the external contours of the pipelines based on the external contour of each pipeline, deciding whether a gradient of each pixel point is the largest among surrounding pixel points with a same gradient direction, and if so, reserving a current pixel point, otherwise removing the current pixel point;

deciding whether the number of pixel points of the external contour of the current pipeline is less than a set threshold, and extracting the pixel points of the external contour of the current pipeline, so as to filter external contours of M pipelines among the external contours of the N pipelines, wherein $1 \leq M \leq N$;

further using a convex hull function on the screened external contours of the M pipelines to obtain each pixel point forming the contour around the entire pipeline, so as to obtain the accurate external contours of the M pipelines; and

obtaining the number of pipelines according to the number of the external contours.

18. The BIM-based prefabricated building design system as claimed in claim 14, wherein the market price statistics module comprises an object positioning sub-module, a matching and supplementation sub-module, and a pipeline-related data sub-module;

the object positioning sub-module is configured to position commodities similar to the pipelines in the market;

the matching and supplementation sub-module is configured to supplementing the similar commodity by combining a fuzzy matching method; and

the pipeline-related data sub-module is configured to acquire the pipeline commodities and related data of products similar to the pipelines according to the supplemented similar commodities.

19. The BIM-based prefabricated building design system as claimed in claim 18, wherein positioning the commodities similar to the pipelines in the market specifically comprises:

using a clustering algorithm to position a similar product;

manually labeling characteristic attributes of the pipelines;

manually labeling searchable approximate corpora similar to the pipelines;

establishing a similarity search language model based on a natural language processing technology and the approximate corpora; and

clustering the commodities similar to the pipelines based on a semi-supervised natural language processing technology and the similarity search language model.

20. A BIM-based prefabricated building simulation assembly method, applied to the assembly system as claimed in any one of claims 1 to 19, and comprising the following steps:

S1, collecting data information of a building to be assembled, and analyzing the data information;
S2, constructing a BIM model of a prefabricated building according to the data information;
S3, exporting a building component drawing according to the BIM model; and
S4, performing assembly path planning on a manufactured building component, and performing assembly based on a planned path.

EP 4 773 032 A1

| Data acquisition module | BIM modeling module | Drawing generation module | Component processing module | Assembly module | Verification module |

**Fig. 1**

| Data acquisition module |

⇩

| Construction simulation module |

⇩ ⇧

| Scenario simulation module |

⇩

| Three-dimensional display module |

**Fig. 2**

| Collect basic data of a place to be assembled; and analyze the basic data to obtain the type and number of assembled components, and generate a simulation component |

| Perform assembly construction on the simulation component, and perform analysis warning on data during assembly |

| Match different application scenarios for the places to be assembled after virtual assembly, and perform data analysis and optimization on the places to be assembled in different application scenarios |

| Perform three-dimensional display on the optimized final assembly solution |

**Fig. 3**

25

| Room model construction module | Facility model construction module | Device model construction module |
|---|---|---|

| Simulation assembly module | Collision warning module |
|---|---|

| Solution recording module |
|---|

**Fig. 4**

| Model database |
|---|

| Design module |
|---|

| BIM assembly module |
|---|

| Load testing module |
|---|

**Fig. 5**

Generate and store 3D models of building materials required for building the laboratory — S1

Design the chemical laboratory — S2

Based on a BIM technology, perform simulation assembly by using the 3D models and laboratory design — S3

Perform a load test on the assembled laboratory model — S4

**Fig. 6**

Three-dimensional modeling module

Simulation module

Parameter setting module

Visualization module

**Fig. 7**

```
┌─────────────────────────────────────────────┐
│            BIM modeling module              │
└─────────────────────────────────────────────┘
                      │
┌─────────────────────────────────────────────┐
│     Pipeline classification and counting     │
│                  module                     │
└─────────────────────────────────────────────┘
                      │
┌─────────────────────────────────────────────┐
│          Market price statistics module      │
└─────────────────────────────────────────────┘
                      │
┌─────────────────────────────────────────────┐
│          Pipeline cost accounting module     │
└─────────────────────────────────────────────┘
```

**Fig. 8**

```
╭─────────────────────────────────────────────╮
│ Collect an image of a device to be riveted,  │
│ and perform pre-processing on the image of    │
│ the device to be riveted, so as to obtain a   │
│ pre-processed image                          │
╰─────────────────────────────────────────────╯
                      │
                      ▼
╭─────────────────────────────────────────────╮
│ Perform positioning detection on the pre-     │
│ processed image to obtain a riveting point     │
│ position                                     │
╰─────────────────────────────────────────────╯
                      │
                      ▼
╭─────────────────────────────────────────────╮
│ Plan a riveting path based on the riveting    │
│ point position to obtain a riveting path, and │
│ achieve automatic riveting based on the       │
│ riveting path                                │
╰─────────────────────────────────────────────╯
```

**Fig. 9**

```
┌─────────────────────────────────────────────┐
│          Image acquisition module            │
└─────────────────────────────────────────────┘
                      │
                      ▼
┌─────────────────────────────────────────────┐
│              Positioning module              │
└─────────────────────────────────────────────┘
                      │
                      ▼
┌─────────────────────────────────────────────┐
│             Path planning module             │
└─────────────────────────────────────────────┘
                      │
                      ▼
┌─────────────────────────────────────────────┐
│               Mechanical arm                 │
└─────────────────────────────────────────────┘
```

**Fig. 10**

$g\,(i,\,j)$

$M_g$

$d$

$c$

$O$      $a$      $b$      $M_f$    $f(i,\,j)$

**Fig. 11**

Image acquisition module

↓

Processing module

↓

Evaluation module

↓

Display module

**Fig. 12**

## INTERNATIONAL SEARCH REPORT

| International application No. |
| --- |
| **PCT/CN2024/111500** |

| A. | CLASSIFICATION OF SUBJECT MATTER |
| --- | --- |

G06F 30/13(2020.01)i

According to International Patent Classification (IPC) or to both national classification and IPC

| B. | FIELDS SEARCHED |
| --- | --- |

Minimum documentation searched (classification system followed by classification symbols)

IPC: G06F

Documentation searched other than minimum documentation to the extent that such documents are included in the fields searched

Electronic data base consulted during the international search (name of data base and, where practicable, search terms used)

CNTXT, WPABSC, ENTXTC, WPABS, ENTXT, VEN, 中国期刊网全文数据库, CJFD: 北京戴纳实验科技有限公司, 迟海鹏, 张怀东, 邢希学, 奚晓鹏, 张京军, 龚长华, BIM, 建筑, 信息, 建模, 模型, 装配, 拼装, 数据, 采集, 图纸, 校验, 路径, 环境, 方案, 吊装, 图形, 预警, 碰撞, 荷载, 三维, 展示, 显示, 扫描, 管道, 颜色, 像素, fabricat+, assembly, BIM, building, information, model+, module, path, check+, data, collect+, drawing, scan+, display, pipe+, load+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 117910092 A (BEIJING DYNAFLOW LAB SOLUTIONS CO., LTD.) 19 April 2024 (2024-04-19)<br>claims 1-8, description, paragraphs 0045-0079, and figure 1 | 1-8, 20 |
| PY | CN 117910092 A (BEIJING DYNAFLOW LAB SOLUTIONS CO., LTD.) 19 April 2024 (2024-04-19)<br>claims 1-8, description, paragraphs 0045-0079, and figure 1 | 9-12 |
| PY | CN 117910089 A (BEIJING DYNAFLOW LAB SOLUTIONS CO., LTD.) 19 April 2024 (2024-04-19)<br>claims 1-2 | 9-10 |
| PY | CN 117910091 A (BEIJING DYNAFLOW LAB SOLUTIONS CO., LTD.) 19 April 2024 (2024-04-19)<br>claim 1 | 11 |

| ✓ | Further documents are listed in the continuation of Box C. | ✓ | See patent family annex. |
| --- | --- | --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 November 2024** | **08 November 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/111500** |

**C.      DOCUMENTS CONSIDERED TO BE RELEVANT**

| Category* | Citation of document, with indication, where appropriate, of the relevant passages | Relevant to claim No. |
| --- | --- | --- |
| PY | CN 117910090 A (BEIJING DYNAFLOW LAB SOLUTIONS CO., LTD.) 19 April 2024 (2024-04-19)<br>      claim 1 | 12 |
| A | CN 113987655 A (GUANGDONG BRIGHT DREAM ROBOTICS CO., LTD.) 28 January 2022 (2022-01-28)<br>      description, paragraphs 0070-0158, and figures 1-4 | 1-20 |
| A | CN 109344560 A (ANHUI GUOHUA CONSTRUCTION PROJECT MANAGEMENT CO., LTD.) 15 February 2019 (2019-02-15)<br>      entire document | 1-20 |
| A | CN 109408903 A (DINGCHEN CONSTRUCTION MANAGEMENT CO., LTD.) 01 March 2019 (2019-03-01)<br>      entire document | 1-20 |
| A | CN 116882009 A (HAINAN HENGXING BUILDING TECHNOLOGY CO., LTD.) 13 October 2023 (2023-10-13)<br>      entire document | 1-20 |
| A | KR 20160041281 A (HYUNDAI ENGINEERING & CONSTRUCTION CO., LTD.) 18 April 2016 (2016-04-18)<br>      entire document | 1-20 |

Form PCT/ISA/210 (second sheet) (July 2022)

# EP 4 773 032 A1

**INTERNATIONAL SEARCH REPORT**
**Information on patent family members**

International application No.

**PCT/CN2024/111500**

| Patent document cited in search report | | | Publication date (day/month/year) | Patent family member(s) | | | Publication date (day/month/year) |
|---|---|---|---|---|---|---|---|
| CN | 117910092 | A | 19 April 2024 | None | | | |
| CN | 117910089 | A | 19 April 2024 | None | | | |
| CN | 117910091 | A | 19 April 2024 | None | | | |
| CN | 117910090 | A | 19 April 2024 | None | | | |
| CN | 113987655 | A | 28 January 2022 | None | | | |
| CN | 109344560 | A | 15 February 2019 | None | | | |
| CN | 109408903 | A | 01 March 2019 | None | | | |
| CN | 116882009 | A | 13 October 2023 | None | | | |
| KR | 20160041281 | A | 18 April 2016 | KR | 101662651 | B1 | 05 October 2016 |

Form PCT/ISA/210 (patent family annex) (July 2022)

**REFERENCES CITED IN THE DESCRIPTION**

**Patent documents cited in the description**

- CN 202311834483
- CN 202311834491
- CN 202311840242
- CN 202311841263
- CN 202311840424
- CN 202311841390
- CN 202311834148
- CN 202311841400